# EUROPÄISCHE PATENTANMELDUNG

(11) **EP 0 785 623 A2**
(43) Veröffentlichungstag der Anmeldung: **23.07.1997**
(21) Anmeldenummer: 96120375.9
(22) Anmeldetag: 18.12.1996
(51) Int. Cl.: H03K 3/037, H03K 3/356

(54) **Statische Halteglieder mit einphasigem Steuersignal**

(30) Priorität: 16.01.1996 DE 19601370
(71) Anmelder: SIEMENS AKTIENGESELLSCHAFT, 80333 München (DE)
(72) Erfinder: Kleine, Ulrich, Prof.-Dr., 38350 Helmstedt (DE)

(57) **Zusammenfassung**

Der Anmeldungsgegenstand betrifft statische Halteglieder (Latches), die nur aus rein statischen Gattern (1,2) aufgebaut sind und daher im stationären Zustand eine große Störsicherheit aufweisen und somit insbesondere für einen Niedervolt-Betrieb geeignet sind. Bei einem einphasigem Halteglied ist, aufgrund der geringeren Verdrahtungskapazität der Steuerleitungen, die Verlustleistung besonders gering, weshalb es insbesondere in digitalen Schaltungen mit hohen Datenraten vorteilhaft eingesetzt werden kann. Der Vorteil des Anmeldegegenstands liegt vor allem in der geringen Anzahl der hierfür benötigten Transistoren.

## Beschreibung

Unter einem Halteglied (Latch) wird hier eine digitale Schaltung mit einem Dateneingang, einem Datenausgang und einem oder mehreren Steuereingängen verstanden. Werden die Steuereingänge aktiviert, so erscheint das am Eingang anliegende Datenwort nicht invertiert oder invertiert am Datenausgang. Die Schaltung des Halteglieds ist in diesem Betriebszustand transparent. Im Falle nicht aktiver Steuerleitungen bleibt der Zustand der letzten Transparentphase am Ausgang erhalten und die Schaltung ist in diesem Betriebszustand nicht transparent. Einphasige Halteglieder besitzen gegenüber zwei- und mehrphasigen Haltegliedern den Vorteil, daß bei ausreichender Steuersignalsteilheit keine sogenannten Glitches auftreten. Glitches sind Fehlfunktionen in Haltegliedern, wobei zum Beispiel aufgrund eines unzureichend steilen Steuersignals oder bei mehrphasigen Haltegliedern aufgrund unterschiedlicher Laufzeiten der einzelnen Steuersignale (clock skew) Datenworte im nicht transparenten Betriebsmodus durch das Halteglied 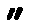 durchrutschen". Ein weiterer Vorteil der einphasigen Halteglieder ist die geringere Kapazität der Steuersignalleitungen und damit auch die geringere Verlustleistung, die durch das Umladen der Steuersignalleitungen verursacht wird. Einphasige Halteglieder werden besonders in digitalen Schaltungen mit hohen Datenraten eingesetzt.

Aus der Veröffentlichung N. Weste und K. Eshraghian mit dem Titel Principles of CMOS VLSI Design. A System Perspective, Addison-Wesley, 1985, Seiten 214 bis 216 ist ein statisches einphasiges Halteglied bekannt, welches jedoch nachteiligerweise aus relativ komplexen Gattern bzw. relativ vielen Transistoren aufgebaut ist.

Die der Erfindung zugrundeliegende Aufgabe besteht nun darin, ein statisches Halteglied anzugeben, bei dem zur Ansteuerung nur ein einziges Übernahmesignal bzw. Steuersignal erforderlich ist, das mit reinen statischen Gattern aufgebaut ist und das eine möglichst geringe Anzahl von Transistoren aufweist.

Diese Aufgabe wird erfindungsgemäß durch die Merkmale des Patentanspruchs 1 oder 4 gelöst. Die Unteransprüche betreffen vorteilhafte Ausgestaltungen der Erfindung.

Die Erfindung wird nachfolgend anhand der Zeichnungen näher erläutert. Dabei zeigen
- Figur 1 bis 4: Logikdiagramme für verschiedene Ausgestaltungen des erfindungsgemäßen Halteglieds und
- Figur 5 bis 8: Schaltbilder zu den Logikdiagrammen von Figur 1 bis 4.

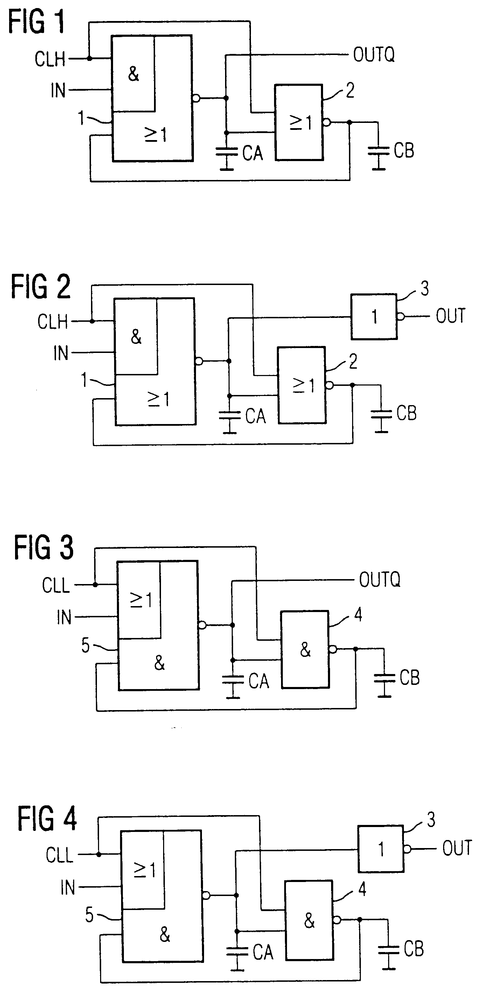

In Figur 1 ist das Logikdiagramm des erfindungsgemäßen Haltegliedes in der Ausgestaltung eines high-aktiven invertierenden Haltegliedes dargestellt und weist ein ANDNOR-Gatter 1 und ein NOR-Gatter 2 auf. Ein erster AND-Eingang von Gatter 1 ist mit einem Eingang IN des Halteglieds und ein zweiter AND-Eingang ist mit einem Steuersignal CLH beschaltet, das zugleich auch einem ersten Eingang der NOR-Schaltung 2 zugeführt ist. Der Ausgang des ANDNOR-Gatters 1 stellt gleichzeitig einen negierten Ausgang des Halteglieds mit einem Ausgangssignal OUTQ dar, der gegenüber Masse eine Knotenkapazität CA aufweist und der mit einem zweiten Eingang des NOR-Gatters 2 verbunden ist. Ein Ausgang des NOR-Gatters 2 weist gegenüber Masse eine Knotenkapazität CB auf und ist mit einem NOR-Eingang des AND-NOR-Gatters 1 verbunden.

Ist das Steuersignal CLH auf logisch 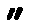 high", so ist der Ausgang des NOR-Gatters 2 logisch 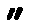 low". Somit bestimmt der Ausgang des ANDNOR-Gatters den logischen Pegel des Ausgangssignals OUTQ, da der zweite NOR-Eingang des ANDNOR-Gatters 1 logisch 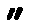 low" ist. Die AND-Verknüpfung des Eingangssignals IN und des Steuersignals CLH und die anschließende ODER-Verknüpfung mit Negierung bewirkt, daß das invertierte Eingangssignal IN am Ausgang erscheint. Das Halteglied ist in diesem Betriebszustand transparent und invertiert. Ist das Steuersignal auf logisch 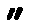 low", arbeitet die Schaltung als Flip-Flop. Der Ausgang des ANDNOR-Gatters 1 wird allein durch den Pegel am Ausgang des NOR-Gatters bestimmt, da der AND-Ausgang auf logisch 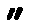 low" liegt. Wahrend des Umschaltens von der transparenten in die nicht transparente Phase liegt an beiden NOR-Eingängen des ANDNOR-Gatters ein logischer 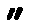 low"-Pegel. Dies fuhrt zu einem 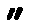 high"-Pegel am Ausgang des ANDNOR-Gatters und gegebenenfalls zum Überschreiben des Ausgangspegels OUTQ. Damit das Flip-Flop richtig speichert und die oben beschriebenen Glitches nicht auftreten, ist die Schaltung so zu dimensionieren, daß die Gatterlaufzeit des NOR-Gatters kürzer ist als die des ANDNOR-Gatters. Diese Bedingung ist jedoch in jedem Fall erfüllt, da das ANDNOR-Gatter komplexer als das NOR-Gatter ist und die Knotenkapazität CA durch die größere Anzahl der angeschlossenen Elemente in jedem Fall größer ist als die Knotenkapazität CB.

In Figur 2 ist das Logikdiagramm eines 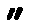 high-aktiven" nicht invertierenden Halteglieds gezeigt. Die zusätzliche Invertierung geschieht durch Nachschalten eines Inverters 3 am Ausgang des in Figur 1 gezeigten Haltegliedes. Der zusätzliche Inverter kann aber auch zur Treiberanpassung benutzt werden.

In Figur 3 ist ein erfindungsgemäßes Halteglied in der Ausgestaltung eines 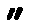 low-aktiven" invertierenden Haltegliedes dargestellt, das sich von dem in Figur 1 dargestellten Halteglied lediglich dadurch unterscheidet, daß an Stelle des ANDNOR-Gatters 1 ein ORNAND-Gatter 5 und an Stelle des NOR-Gatters 2 ein NAND-Gatter 4 vorgesehen sind sowie das Steuersignal an Stelle von CLH mit CLL bezeichnet ist. Ist das Steuersignal (CLL) auf logisch 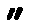 low", so ist der Ausgang des NAND-Gatters logisch 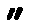 high". Somit ist der zweiten NAND-Eingang des ORNAND-Gatters auf logisch 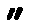 high" und der OR-Ausgang des ORNAND-Gatters bestimmt den logischen Pegel des Ausgangssignals OUTQ. Daß das Steuersignal CLL logisch 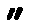 low" ist, bestimmt allein das Eingangssignal IN den Ausgangspegel. Das Halteglied ist in diesem Betriebszustand transparent und invertiert das Eingangssignal IN. Ist das Steuersignal auf logisch 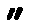 high", arbeitet die Schaltung statisch wieder als Flip-Flop. Der Ausgang des NAND-Gatters wird wieder durch das Ausgangssignals OUTQ bestimmt, da das Steuersignal CLL logisch 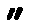 high" ist, und der logische Pegel am Ausgang des ORNAND-Gatters wird allein durch den Pegel am Ausgang des NAND-Gatters bestimmt. Zur Gewährleistung eines richtigen Umschaltens von der transparenten in die nicht transparente Phase ist es wieder erforderlich, daß das zweite Gatter, das heißt das NAND-Gatter, schneller schaltet als das ORNAND-Gatter. Durch die größere Komplexität des ORNAND-Gatters und die größere Knotenkapazität am Ausgang des ORNAND-Gatters ist dies bei üblicher Dimensionierung der Gatter bereits erfüllt.

In Figur 4 ist ein Logikdiagramm des erfindungsgemäßen Halteglieds in der Ausführungsform eines 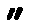 low-activen" nicht invertierenden Halteglieds dargestellt, das sich lediglich von dem in Figur 3 dargestellten Halteglied durch einen zusätzlichen Inverter am Ausgang des Halteglieds, der auch zur Treiberanpassung genutzt werden kann, unterscheidet.

Die Ausdrucke 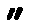 high-aktiv" und 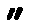 low-aktiv" beziehen sich auf die Transparentphase der Halteglieder. 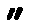 High-aktive" Halteglieder sind transparent bei logischen 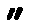 High"-Pegeln auf den Steuerleitungen.

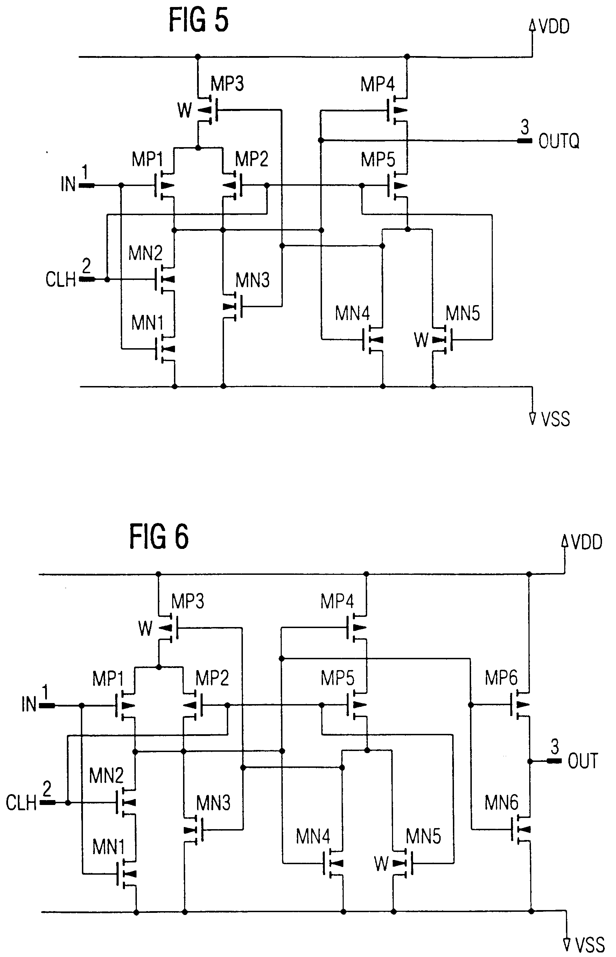

In Figur 5 ist eine CMOS-Schaltung zum Logikdiagramm von Figur 1 auf Transistorniveau dargestellt, wobei die ANDNOR-Schaltung 1 n-Kanal-MOS-Transistoren MN1 ... MN3 und p-Kanal-MOS-Transistoren MP1 ... MP3 aufweist und das NOR-Gatter 2 n-Kanal-MOS-Transistoren MN4 und MN5 sowie p-Kanal-MOS-Transistoren MP4 und MP5 umfaßt. Die beiden Transistoren MP1 und MP2 sind dabei parallel geschaltet und über den Transistor MP3 mit der Versorgungsspannung VDD verbunden. Die beiden Transistoren MN1 und MN2 sind in Reihe geschaltet und ein nicht mit dem Transistor MP3 verbundener Verbindungsknoten der beiden Transistoren MP1 und MP2, der das Ausgangssignal OUTQ fuhrt, ist sowohl über die Reihenschaltung der Transistoren MN1 und MN2 als auch über den Transistor MN3 mit Bezugspotential VSS verbunden. Die Gates der beiden Transistoren MP1 und MN1 sind dabei mit dem Eingangssignal IN des Halteglieds und die Gates der Transistoren MP2 und MN2 mit dem Steuersignal CLH verbunden. Die beiden Gates der Transistoren MP3 und MN3 sind miteinander verbunden und stellen den NOR-Eingang der ANDNOR-Schaltung 1 dar, der mit dem Ausgangsknoten der NOR-Schaltung 2 verbunden ist. Die Transistoren MP4 und MP5 sind in Reihe geschaltet und die Transistoren MN4 und MN5 sind parallel geschaltet, wobei der Verbindungsknoten zwischen den Transistoren MN4 und MN5 den Ausgang des NOR-Gatters 2 bildet, ein Anschluß des Transistors MP4 mit der Versorgungsspannung VDD und jeweils ein Anschluß der Transistoren MN4 und MN5 mit Bezugspotential VSS verbunden ist. Die Gates der Transistoren MP4 und MN4 sind mit dem Ausgangssignal OUTQ und die Gates der Transistoren MP5 und MN5 sind mit dem Steuersignal CLH beschaltet.

Um die oben beschriebenen Fehlfunktionen (Glitches) in den Haltegliedern weiter zu reduzieren, kann beispielsweise die Gateweite W der Transistoren MP3 und MN5 kleiner gewählt werden als bei den übrigen Transistoren des Halteglieds.

Das in Figur 6 dargestellte Schaltbild entspricht dem in Figur 2 dargestellten Logikdiagramm und unterscheidet sich hinsichtlich des in Figur 5 gezeigten Haltegliedes nur durch den am Ausgang nachgeschalteten Inverter, der hier aus einer Reihenschaltung eines n-Kanal-MOS-Transistoren MN6 und eines p-Kanal-MOS-Transistors MP6 besteht, wobei der Ausgang mit dem Signal OUT über den Transistor MP6 mit der Versorgungsspannung VDD und über den Transistor MN6 mit Bezugspotential verbunden ist.

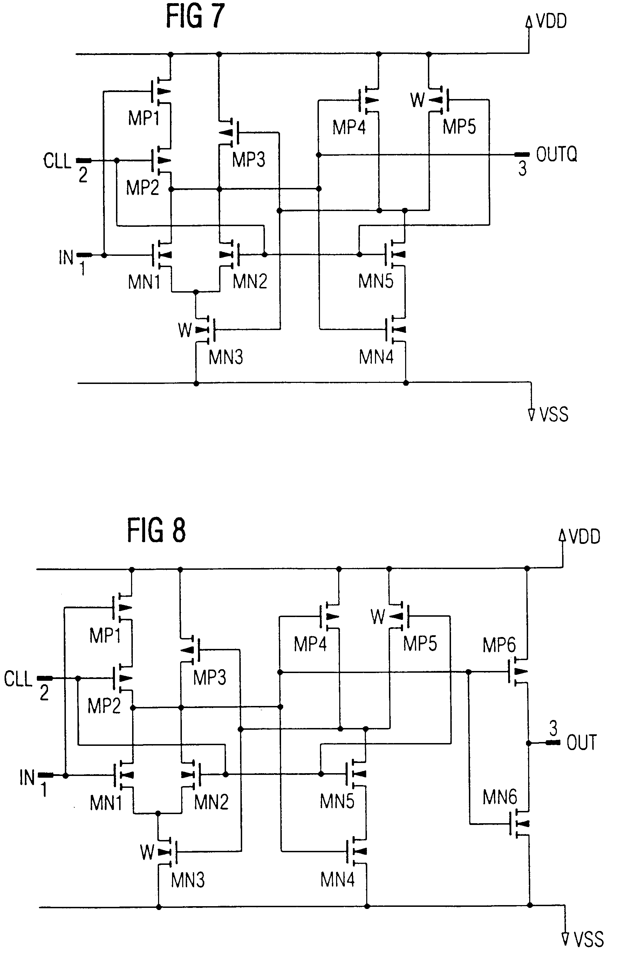

In Figur 7 ist eine Schaltung dargestellt, die dem Logikdiagramm von Figur 3 entspricht, wobei die ORNAND-Schaltung 5 wiederum n-Kanal-Transistoren MN1 ... MN3 und p-Kanal-Transistoren MP1 ... MP3 und die NAND-Schaltung 4 n-Kanal-Transistoren MN4 und MN5 sowie p-Kanal-Transistoren MP4 und MP5 aufweist. Hierbei sind die Transistoren MN1 und MN2 parallel geschaltet und ein erster Knoten der Parallelschaltung über den Transistor MN3 mit Bezugspotential VSS verbunden. Ein weiterer Verbindungsknoten der Parallelschaltung der beiden Transistoren MN1 und MN2 stellt den Ausgang mit dem Signal OUTQ dar und ist zum einen über eine Reihenschaltung aus den Transistoren MP1 und MP2 und zum anderen über den Transistor MP3 mit der Versorgungsspannung VDD verbunden. Die Gates der Transistoren MP1 und MN1 sind mit dem Eingangssignal IN des Halteglieds und die Gates der Transistoren MN2 und MP2 mit dem Steuersignal CLL verbunden. Die Gates der Transistoren MN3 und MP3 sind gemeinsam mit dem Ausgangsknoten der NAND-Schaltung 4 verbunden. Der Ausgangsknoten der NAND-Schaltung 4 ist über eine Reihenschaltung aus den Transistoren MN4 und MN5 mit Bezugspotential und über eine Parallelschaltung aus den Transistoren MP4 und MP5 mit Versorgungsspannung VDD verbunden. Die Gates der Transistoren MP4 und MN4 sind mit dem Ausgangssignal OUTQ und die Gates der Transistoren MN5 und MP5 mit dem Steuersignal CLL beschaltet.

Eine weitere Möglichkeit zur Reduzierung der Fehlfunktionen des Haltegliedes besteht hier ebenfalls darin, die Kanalweite W der Transistoren MN3 und MP5 kleiner zu wählen als die Kanalweiten der übrigen Transistoren.

In Figur 8 ist ein Schaltbild des Logikdiagramms von Figur 4 dargestellt, bei dem gegenüber dem Logikdiagramm von Figur 3 ein zusätzlicher Inverter 3 vorgesehen ist, der in Figur 8 wiederum durch eine Reihenschaltung aus Transistoren MN6 und MP6 besteht, wobei der Ausgang OUT über den Transistor MP6 mit der Versorgungsspannung VDD und über den Transistoren MN6 mit Bezugspotential VSS verbunden ist.

## Patentansprüche

1. Statisches Halteglied, bei dem ein ANDNOR-Gatter (1) und ein NOR-Gatter (2) vorgesehen sind, bei dem ein erster AND-Eingang des ANDNOR-Gatters mit einem Eingang (IN) des Halteglieds und ein weiterer AND-Eingang des ANDNOR-Gatters mit einem Steuersignaleingang (CLH) beschaltet sind und ein Ausgang des ANDNOR-Gatters (1) einen Ausgang (OUTQ) des Haltegliedes bildet, der mit einem ersten Eingang des NOR-Gatters (2) verbunden ist, und bei dem ein zweiter Eingang des NOR-Gatters (2) mit dem Steuersignaleingang (CLH) beschaltet ist und ein Ausgang des NOR-Gatters (2) mit einem NOR-Eingang des ANDNOR-Gatters (1) verbunden ist.

2. Halteglied nach Anspruch 1,
bei dem das ANDNOR-Gatter (1) einen ersten, einen zweiten und einen dritten n-Kanal-MOS-Feldeffekttransistor (MN1 ... MN3) sowie einen ersten, zweiten und dritten p-Kanal-MOS-Transistor (MP1 ... MP3) aufweist, bei dem der Ausgang (OUTQ) des Halteglieds über eine Reihenschaltung aus dem ersten und dritten p-Kanal-MOS-Transistor (MP1, MP3) sowie über eine Reihenschaltung aus dem zweiten und dritten p-Kanal-MOS-Transistor (MP2, MP3) mit einer Versorgungsspannung (VDD) und über eine Reihenschaltung des ersten und zweiten n-Kanal-MOS-Transistors (MN1, MN2) sowie über den dritten n-Kanal-MOS-Transistor (MN3) mit Bezugspotential (VSS) verbunden sind, wobei die Gates des ersten n-Kanal- und p-Kanal-Transistors mit dem Eingang (IN) des Halteglieds, die Gates des zweiten p-Kanal- und n-Kanal-MOS-Transistors mit dem Steuersignaleingang (CLH) und die Gates des dritten p-Kanal- und dritten n-Kanal-MOS-Transistors mit dem Ausgang des NOR-Gatters (2) beschaltet sind, bei dem das NOR-Gatter (2) einen vierten und fünften n-Kanal-MOS-Transistor (MN4, MN5) sowie einen vierten und fünften p-Kanal-MOS-Transistor (MP4, MP5) aufweist und bei dem der Ausgang des NOR-Gatters über eine Reihenschaltung des vierten und fünften p-Kanal-MOS-Transistors mit der Versorgungsspannung VDD und über eine Parallelschaltung des vierten und fünften n-Kanal-MOS-Transistors mit Bezugspotential (VSS) verbunden ist, wobei die Gates des vierten n-Kanal-MOS-Transistors und vierten p-Kanal-MOS-Transistors mit dem Ausgang (OUTQ) del Halteglieds und jeweils das Gate des fünften n-Kanal-MOS-Transistors und p-Kanal-MOS-Transistors mit dem Steuersignaleingang (CLH) beschaltet sind.

3. Halteglied nach Anspruch 1 oder 2,
bei dem dem Ausgang des ANDNOR-Gatters (1) ein Inverter (3) zur Bildung eines nicht invertierten Ausgangs (OUT) nachbeschaltet ist.

4. Statisches Halteglied, bei dem ein ORNAND-Gatter (5) und ein NAND-Gatter (4) vorgesehen sind, bei dem ein erster OR-Eingang des ORNAND-Gatters mit einem Eingang (IN) des Halteglieds und ein weiterer OR-Eingang des ORNAND-Gatters mit einem Steuersignaleingang (CLL) beschaltet sind und ein Ausgang des ORNAND-Gatters (5) einen Ausgang (OUTQ) des Haltegliedes bildet, der mit einem ersten Eingang des NAND-Gatters (4) verbunden ist, und bei dem ein zweiter Eingang des NAND-Gatters (4) mit dem Steuersignaleingang (CLL) beschaltet ist und ein Ausgang des NAND-Gatters (4) mit einem NAND-Eingang des ORNAND-Gatters (5) verbunden ist.

5. Halteglied nach Anspruch 4,
bei dem das ORNAND-Gatter (5) einen ersten, einen zweiten und einen dritten n-Kanal-MOS-Feldeffekttransistor (MN1 ... MN3) sowie einen ersten, zweiten und dritten p-Kanal-MOS-Transistor (MP1 ... MP3) aufweist, bei dem der Ausgang (OUTQ) des Halteglieds über eine Reihenschaltung aus dem ersten und zweiten p-Kanal-MOS-Transistor (MP1, MP2) sowie über einen dritten p-Kanal-MOS-Transistor (MP3) mit einer Versorgungsspannung (VDD) und über eine Reihenschaltung des ersten und dritten n-Kanal-MOS-Transistors (MN1, MN3) sowie über den zweiten und dritten n-Kanal-MOS-Transistor (MN2, MN3) mit Bezugspotential (VSS) verbunden sind, wobei die Gates des ersten n-Kanal- und p-Kanal-Transistors mit dem Eingang (IN) des Halteglieds, die Gates des zweiten p-Kanal- und n-Kanal-MOS-Transistors mit dem Steuersignaleingang (CLL) und die Gates des dritten p-Kanal- und dritten n-Kanal-MOS-Transistors mit dem Ausgang des NAND-Gatters (4) beschaltet sind, bei dem das NAND-Gatter (4) einen vierten und fünften n-Kanal-MOS-Transistor (MN4, MN5) sowie einen vierten und fünften p-Kanal-MOS-Transistor (MP4, MP5) aufweist und bei dem der Ausgang des NAND-Gatters über eine Parallelschaltung des vierten und fünften p-Kanal-MOS-Transistors mit der Versorgungsspannung VDD und über eine Reihenschaltung des vierten und fünften n-Kanal-MOS-Transistors mit Bezugspotential (VSS) verbunden ist, wobei die Gates des vierten n-Kanal-MOS-Transistors und vierten p-Kanal-MOS-Transistors mit dem Ausgang (OUTQ) des Halteglieds und jeweils das Gate des fünften n-Kanal-MOS-Transistors und fünften p-Kanal-MOS-Transistors mit dem Steuersignaleingang (CLL) beschaltet sind.

6. Halteglied nach Anspruch 4 oder 5,
bei dem dem Ausgang des ORNAND-Gatters (5) ein Inverter (3) zur Bildung eines nicht invertierten Ausgangs (OUT) nachgeschaltet ist.
